# FASCICULE DE BREVET EUROPEEN

(11) **EP 2 467 871 B1**
(45) Date de publication et mention de la délivrance du brevet: **23.03.2016**
(21) Numéro de dépôt: 10752079.3
(22) Date de dépôt: 22.07.2010
(51) Int. Cl.: H01L 21/02, H01L 27/15, H01L 33/06, H01L 33/64

(54) **PROCÈDE DE FABRICATION D'UN DISPOSITIF D'ÉMISSION DE LUMIÈRE A BASE DE DIODES ELECTROLUMINESCENTES**
VERFAHREN ZUR HERSTELLUNG EINER LEUCHTDIODENVORRICHTUNG ZUR LICHTEMISSION
METHOD FOR MANUFACTURING A LIGHT-EMITTING DIODE DEVICE FOR EMITTING LIGHT

(30) Priorité: 18.08.2009 FR 0955697
(43) Date de publication de la demande: 27.06.2012
(73) Titulaire: Commissariat à l'Énergie Atomique et aux Énergies Alternatives, 75015 Paris (FR)
(72) Inventeur: GASSE, Adrien, F-38100 Grenoble (FR); GILET, Philippe, F-38470 Teche (FR)
(74) Mandataire: Cabinet Laurent & Charras
(86) Numéro de dépôt international: PCT/FR2010/051553
(87) Numéro de publication internationale: WO 2011/020959

(56) Documents cités:
- WO-A1-2007/055468
- WO-A1-2007/141333
- US-A1- 2005 062 049
- US-A1- 2006 169 993
- KIKUCHI A ET AL: "INGAN/GAN MULTIPLE QUANTUM DISK NANOCOLUMN LIGHT-EMITTING DIODES GROWN ON (111) SI SUBSTRATE" JAPANESE JOURNAL OF APPLIED PHYSICS, JAPAN SOCIETY OF APPLIED PHYSICS, TOKYO,JP, vol. 43, no. 12A, 1 décembre 2004 (2004-12-01), pages L1524-L1526, XP001230716 ISSN: 0021-4922

## Description

### DOMAINE DE L'INVENTION

La présente invention a trait au domaine de la fabrication de dispositifs d'émission de lumière à base de diodes électroluminescentes, notamment de dispositifs d'émission de forte brillance et de grande surface.

### ETAT DE LA TECHNIQUE

Usuellement, un dispositif d'émission de lumière à base de LED (acronyme de l'expression anglo-saxonne « *light emitting dipode* ») est constitué d'un empilement de couches semi-conductrices réalisées par expitaxie sur un substrat de saphir ou de carbure de silicium (SiC) ayant un paramètre de maille adapté au matériau des couches semi-conductrices. Une pluralité de diodes est usuellement simultanément réalisée à l'échelle d'une tranche (« *wafer* »), puis les diodes sont individualisées par découpage. Les puces unitaires ainsi obtenues sont alors reportées, en fonction des applications, sur un substrat de support dit PCB (« *printed circuit board* ») d'un système d'éclairage pour leur alimentation électrique, le nombre de puces reportée sur le PCB étant choisi en fonction de la luminosité souhaitée pour le système d'éclairage.

Toutefois, la fabrication de ce type de LED reste complexe et coûteuse car elle nécessite de très nombreuses étapes, notamment des étapes d'amincissement et/ou de retrait du substrat de croissance d'épitaxie et, le cas échéant, une étape de report des LED sur un PCB.

Mais surtout, une part importante (environ 80%) de l'énergie électrique injectée dans de telles LED est convertie en chaleur. Ce faisant, non seulement le rendement de telles diodes est faible, mais leur durée de vie est sensiblement écourtée si elles subissent un échauffement important. Il se pose ainsi des problèmes de dissipation thermique, d'autant plus cruciaux qu'une forte luminosité du système d'éclairage, et donc un nombre élevé de diodes, est requis. De fait, la dissipation thermique reste le principal frein à la diffusion de ce type de LED.

Usuellement, l'alimentation électrique d'une LED est limitée à quelques watts pour éviter son échauffement à des températures supérieures à 150°C et/ou il est prévu dans le système d'éclairage des dispositifs actifs de refroidissement des diodes (ventilateur, module à effet Peltier, ...).

Afin de réduire les résistances thermiques s'opposant à une bonne dissipation de la chaleur, (notamment la forte résistance thermique des couches permettant de maintenir les LED sur une carte), les LED peuvent également être directement intégrées sur la carte (on parle alors de « *chip on board* »), ce qui permet d'éliminer les résistances thermiques liées au report. Cependant, les opérations d'intégration sont complexes et le gain en dissipation thermique insuffisant.

Récemment, il est apparu des LED à base de nanofils dont l'avantage est de ne pas nécessiter un accord de maille entre le matériau constitutif d'une LED et le substrat de croissance des nanofils. Un large choix de substrat est ainsi possible, et non pas seulement du saphir et du SiC, et notamment des substrats permettant une bonne dissipation thermique de la chaleur produite par la LED, comme par exemple les métaux. On peut par exemple se reporter au document WO 2007/141333 pour une description détaillée de la fabrication d'une telle LED.

Bien que le nombre d'étapes de fabrication soit plus limité, en raison notamment du substrat qui n'est pas retiré, les LED sont toujours produites de manière simultanée puis individualisées et les LED individualisées reportée sur un PCB ou intégrée directement sur une carte. De fait, les étapes de construction d'un système d'éclairage sont encore nombreuses et le report des LED sur un PCB ou leur intégration sur une carte induit de nombreuses résistances thermiques réduisant l'efficacité de la dissipation thermique.

US 2006/0169993 A1 divulgue l'individualisation et connexion en série des LED.

### EXPOSE DE L'INVENTION

Le but de la présente invention est de résoudre le problème susmentionné en proposant un procédé simple de fabrication d'un dispositif d'émission de lumière à base de LED de grande surface, et donc de forte luminosité, ayant des caractéristiques de dissipation thermique améliorée.

A cet effet, un premier procédé consiste en :
▪ la formation d'un support formant échangeur thermique ;
▪ la formation d'une première électrode sur le support;
▪ la croissance de nanofils semi-conducteurs émetteurs de lumière sur la première électrode ;
▪ l'encapsulation des nanofils dans un matériau planarisant ;
▪ la formation, sur le matériau planarisant, d'une seconde électrode apte à transmettre au moins partiellement la lumière émise par les nanofils.

Selon l'invention,
▪ le support présente une face électriquement isolante sur laquelle est formée la première électrode ;
▪ et ce premier procédé comporte :
   ∘ la formation de zones de reprise de contact électrique sur la seconde électrode ;
   ∘ la formation des diodes électroluminescentes par :
      ▪ libération d'une bande de première électrode autour de chaque zone de reprise de contact comportant :
         - la formation d'un masque de délimitation desdites bandes sur la surface de la seconde électrode ;
         - une première gravure chimique du matériau planarisant, la gravure chimique étant stoppée de manière à conserver du matériau planarisant sur la première électrode ;
         - une seconde gravure chimique de la portion de nanofils libérée du matériau planarisant lors de la première gravure chimique ; et
         - une troisième gravure chimique de matériau planarisant restant à l'issue de la première attaque chimique,
      ▪ et la formation d'une tranchée le long de chacune desdites bandes jusqu'à la face électriquement isolante du support ;
   ∘ et la mise en série des diodes électroluminescentes par la connexion électrique des zones de reprise de contact électrique et des bandes de première électrode.
L'invention a également pour objet un second procédé prévu à cet effet qui consiste en :
   ▪ la formation d'un support formant échangeur thermique ;
   ▪ la formation d'une première électrode sur la face électriquement isolante du support;
   ▪ la croissance de nanofils semi-conducteurs émetteurs de lumière sur la première électrode ;
   ▪ la formation, sur l'extrémité libre des nanofils, d'une seconde électrode apte à transmettre au moins partiellement la lumière émise par les nanofil ;
   Selon l'invention,
   ▪ le support présente une face électriquement isolante sur laquelle est formée la première électrode ;
   ▪ les extrémités libres des nanofils sont évasées et contigües de manière à former un support pour la seconde électrode ;
   ▪ la première électrode est réalisée en un matériau sensiblement inerte à une gravure chimique prédéterminée des nanofils,
   ▪ et ce second procédé comporte :
      ∘ la formation de zones de reprise de contact électrique sur la seconde électrode ;
      ∘la formation des diodes électroluminescentes par :
         - libération d'une bande de première électrode autour de chaque zone de reprise de contact comportant la formation d'un masque de délimitation desdites bandes sur la surface de la seconde électrode et l'application de ladite gravure chimique prédéterminée ;
         - et la formation d'une tranchée le long de chacune desdites bandes jusqu'à la face électriquement isolante du support ;
      ∘ la mise en série des diodes électroluminescentes par la connexion électrique des zones de reprise de contact électrique et des bandes de première électrode.

En d'autres termes, les LED à base de nanofils sont toujours conçues de façon simultanée sur un support. Toutefois, selon l'invention, celui-ci présente une face électriquement isolante permettant d'individualiser ultérieurement les puces sans une séparation physique de celles-ci. En outre, la couche de matériau formant la première électrode de chaque LED est dégagée de manière suffisante pour offrir une surface parallèle au support et utilisée pour mettre électriquement en série les LED. Il n'est donc plus besoin d'utiliser une carte imprimée pour l'alimentation individuelle des LED, minimisant ainsi la résistance thermique de l'ensemble. Les LED restent donc avantageusement sur un support choisi pour être un bon dissipateur thermique et comprenant par exemple des ailettes.

En outre, les bandes de première électrode présentent une grande surface pour la reprise de contact lors de la mise en série des LED, et tout en évitant une surgravure lors de la formation des tranchées.

Selon l'invention, la formation du support peut comporter la formation d'ailettes de dissipation thermique sur la face opposée à la face électriquement isolante.

En outre, la formation du support peut également comporter le dépôt d'une couche isolante sur un substrat conducteur d'électricité. Cette couche isolante peut par exemple, être constituée d'une couche de matériau inorganique, notamment du diamant, de l'AlN, du SiC, BN, ou du Si₃N₄ ou du SiO₂.

Selon l'invention, la première électrode peut comporter une première couche de matériau d'interconnexion, notamment en Ti, en Cr, en TiN ou en WN et une seconde couche mince, déposée sur la première couche, de matériau de forte conductivité électrique, notamment du Cu, de l'Au, de l'Ag, du W, du Ni, ou du Pd. La première couche permet l'accroche de la seconde couche.

Les nanofils visés ci-dessus sont avantageusement constitués de ZnO. En outre, la première électrode est par exemple une couche de ZnO.

Les connexions électriques sont avantageusement réalisées par câblage filaire, notamment en fil d'Au.

Avantageusement, un matériau luminophore est déposé sur la seconde électrode pour définir et ajuster la couleur de l'émission de lumière

### BREVE DESCRIPTION DES FIGURES

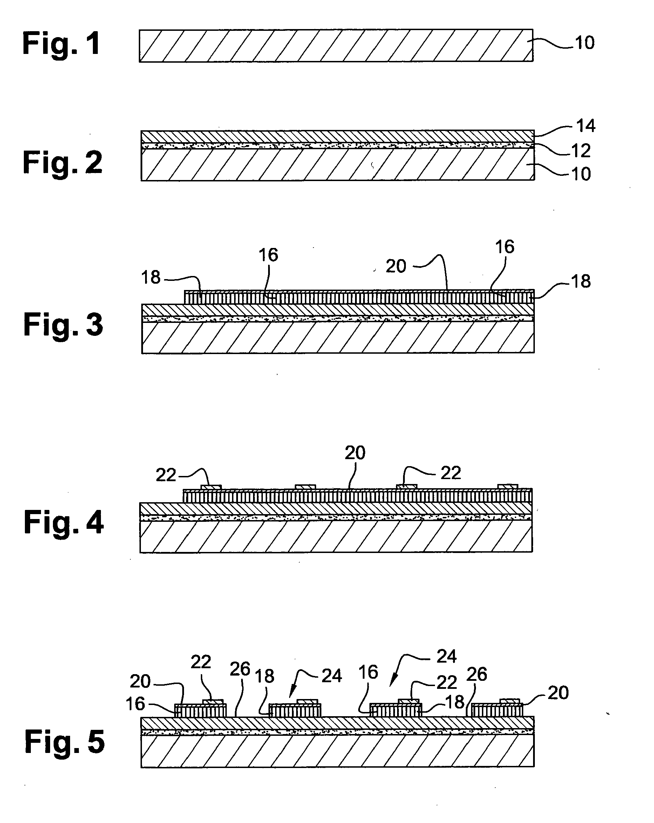

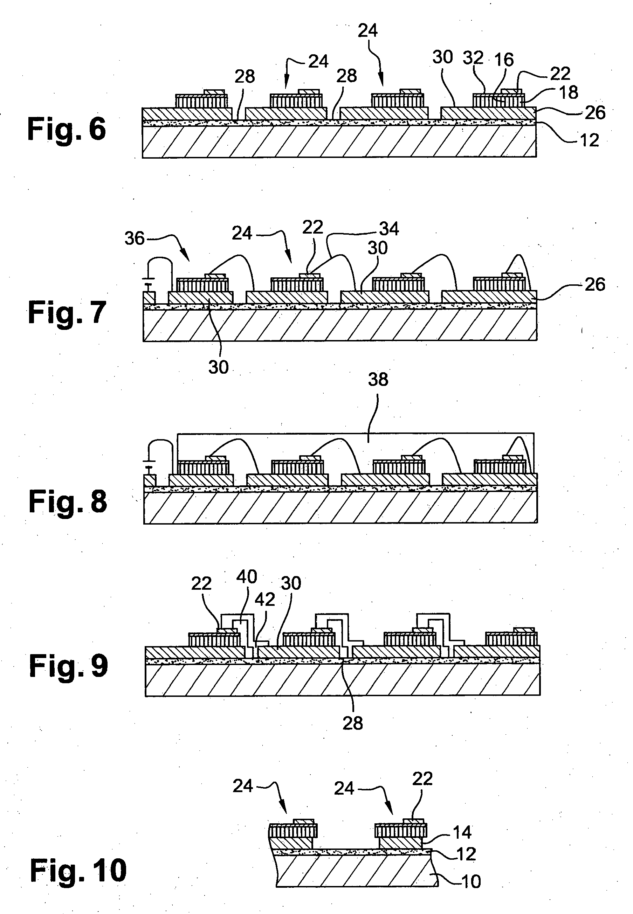

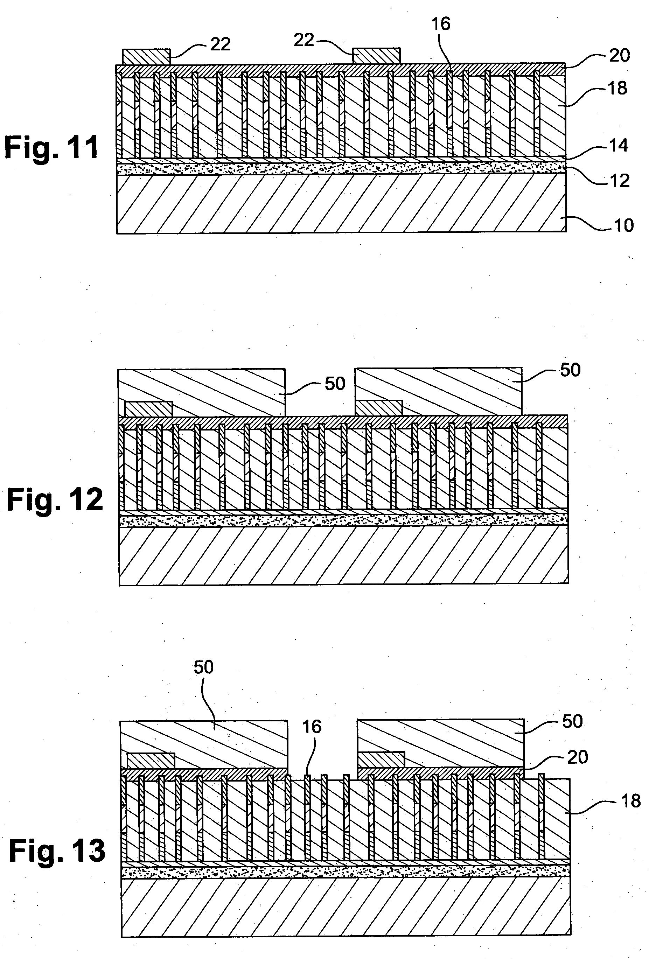

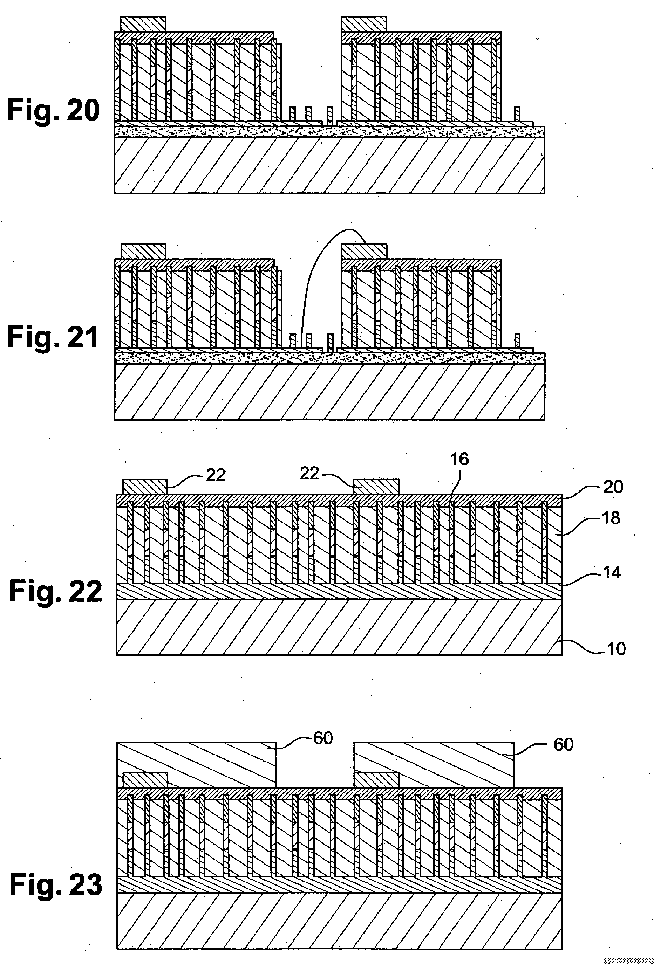

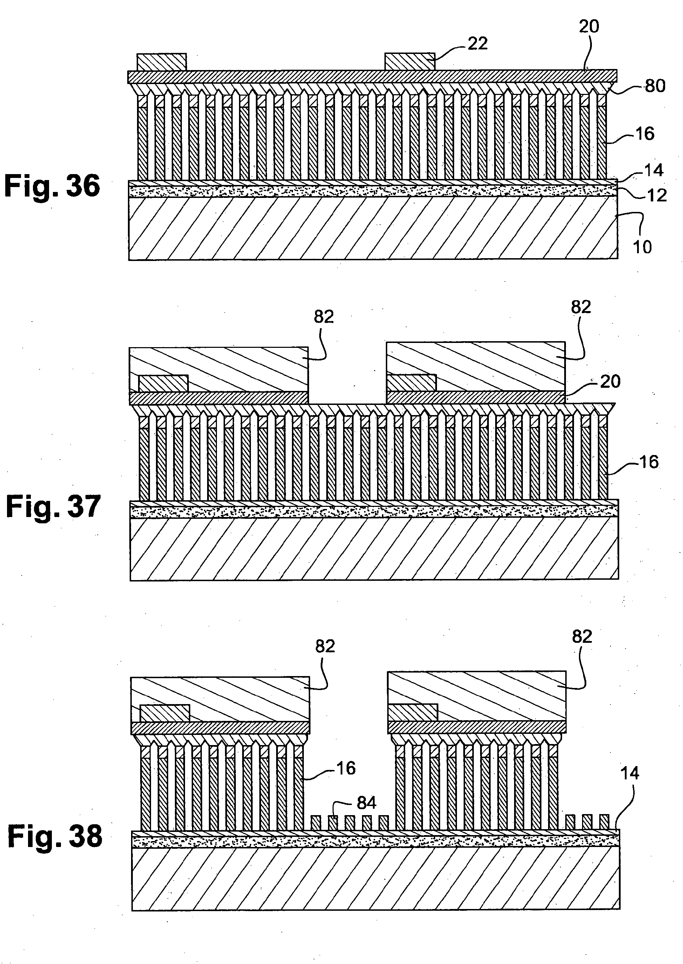

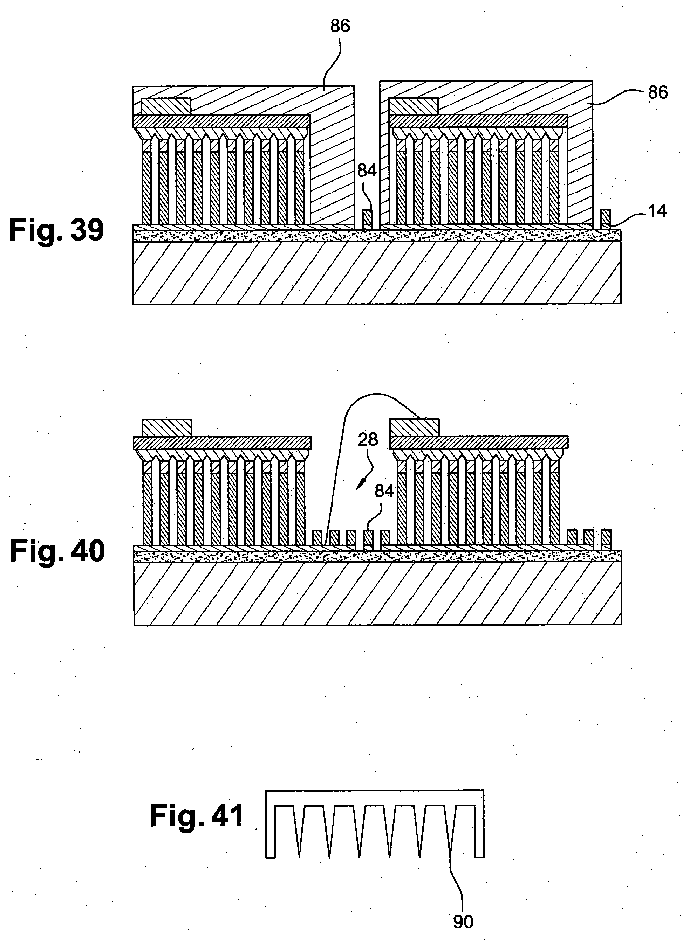

La présente invention sera mieux comprise à la lecture de la description qui suit, donnée uniquement à titre d'exemple, et réalisée en relation avec les dessins annexés, dans lesquels des références identiques désignent des éléments identiques ou analogues, et dans lesnuels :
▪ les figures 1 à 8 illustrent un procédé de fabrication d'un dispositif d'émission de lumière à base de diodes selon l'invention ;
▪ la figure 9 est une vue schématique illustrant une variante d'interconnexion des diodes ;
▪ les figures 11 à 21 illustrent plus en détails les étapes d'individualisation et de connexion électrique des LED pour des nanofils en GaN peu denses ;
▪ les figures 22 à 35 illustrent plus en détail les étapes d'individualisation et de connexion électrique des LED pour des nanofils en ZnO ;
▪ les figures 36 à 40 illustrent plus en détail les étapes d'individualisation et de connexion électrique des LED pour des nanofils en GaN denses et/ou avec une extrémité élargie ; et
▪ la figure 41 est une vue en section d'un mode de réalisation d'un support pour les LED.

### DESCRIPTION DETAILLEE DE L'INVENTION

Les figures 1 à 8 illustrent les principales étapes d'un procédé de fabrication d'un dispositif d'émission de lumière à base de LED selon l'invention.

Le procédé débute (figure 1) par la formation d'un substrat **10** monolithique ou multicouche. Outre la fonction de support pour des éléments constitutifs du dispositif d'émission de lumière à base de LED, le substrat **10** est choisi pour présenter une conductivité thermique élevée afin de dissiper la chaleur produite par les LED qui seront ultérieurement formées sur celui-ci.

Le substrat **10** prend préférentiellement la forme d'un radiateur à ailettes comme cela sera expliqué plus en détail par la suite.

Le ou les matériaux constitutifs du substrat **10** sont sélectionnés de préférence parmi les bons conducteurs thermiques. Par exemple, le substrat **10** est constitué d'un ou plusieurs métaux, ou d'alliage de métaux, comme le cuivre (Cu), l'argent (Ag), le tungstène (W), l'aluminium (Al), le molybdène (Mo), le nickel (Ni), le vanadium (V), le palladium (Pd), le platine (Pt), le titane (Ti) et le fer (Fe).

Le substrat **10** peut également être constitué d'un composite à matrice métallique (comme par exemple du Al-SiC (aluminium-carbure de silicium), du Al-Si (aluminium-silicium), du Cu-diamant), ou d'un semi-conducteur dopé (à base de Si, d'arséniure de galium (AsGa), de phosphure de gallium (GaP), de carbure de silicium (SiC), de nitrure d'aluminium (AlN) ou de nitrure de bore (BN)), ou d'une céramique polycritalline dopée ou non (à base de diamant, de graphite, d'AIN, de SiC, de Si₃N₄, de B₄C ou de WC ou plus généralement tous les carbures et nitrures de métaux de transition).

Dans le cas où le substrat **10** est électriquement conducteur, le procédé se poursuit (figure 2) par la formation, sur le substrat **10** d'une couche mince **12** de quelques micromètres d'épaisseur (par exemple 5 micromètres), à la fois électriquement isolante et de conductivité thermique élevée.

La couche **12** est préférentiellement composée d'un matériau inorganique comme le diamant ou l'un de ses dérivés, comme le DLC par exemple (pour « *diamond like carbon* »), d'une céramique comme l'AIN, le SiC ou le BN, ou encore d'un matériau inorganique comme le Si₃N₄ ou le SiO₂. Préférentiellement, la couche **12** est une couche de diamant polycristallin, par exemple déposée selon une technique de dépôt chimique en phase vapeur (ou CVD pour « *chemical vapor deposition* ») à une température de 800°C, par exemple.

Une couche électriquement conductrice **14** de quelques micromètres d'épaisseur, est alors déposée sur la couche isolante **12,** et présente préférentiellement une forte conductivité électrique. La couche **14** a pour fonction de relier électriquement les nanofils qui seront ultérieurement formés sur celle-ci à un même potentiel.

La couche conductrice **14** forme ainsi une première électrode. La couche conductrice **14** est par exemple une couche métallique formée de Cu, d'Au, de W, de Ni ou de Pd. La couche conductrice est, en variante, réalisée en un même matériau que celui constitutifs des nanofils formés ultérieurement, comme cela sera expliqué plus en détail par la suite. La couche mince **14** est par exemple réalisée à l'aide d'une pulvérisation cathodique, d'une évaporation thermique ou d'une électrolyse.

De manière optionnelle, une couche d'accroche (non représentée), de quelques dixièmes de micromètre, est d'abord déposée sur la couche isolante **12**. La couche d'accroche, par exemple formée de Ti, Cr, TiN, ou WN, augmente ainsi l'adhérence de la couche conductrice **14** déposée sur celle-ci. La couche d'accroché est préférentiellement mise en oeuvre lorsque la couche conductrice **14** est du type métallique et que la couche isolante **12** est en un matériau inorganique, l'adhérence d'un métal sur un matériau inorganique étant faible.

Le procédé se poursuit (figure 3) par la croissance de nanofils **16** en matériau semiconducteur sur la couche conductrice **14**. Chaque nanofil **16** comprend au moins un empilement :
- d'une première zone semi-conductrice d'un premier type, par exemple de type n,
- d'une deuxième zone semi-conductrice comprenant des hétérostructures de multi-puits quantiques, cette zone formant la zone active d'émission de lumière,
- et d'une troisième zone semi-conductrice de type opposé à la première zone, par exemple de type p.

Par exemple, le matériau semi-conducteur constitutif des nanofils est en GaN, en oxyde de zinc (Zn0), en Si, en GaAs ou en GaP. Les hétérostructures de multi-puits quantiques sont alors formées en alliage à base de InGaN pour des nanofils à base de GaN ou d'un alliage à base de ZnMgO pour des alliages à base de ZnO.

On notera que la deuxième zone comprenant les hétérostructures est optionnelle. Dans le cas où celle-ci est omise, la zone active d'émission de lumière est constituée par l'interface entre les deux zones semi-conductrices restantes.

Optionnellement, et préalablement à la croissance des nanofils **16**, une couche réflectrice (non représentée) est déposée sur la couche conductrice **14** ou bien le matériau de la couche, conductrice **16** est également choisi pour ses qualités réflectrices. Par exemple, une couche d'Ag, d'Au ou d'Al est déposée sur la couche **14**.

Les nanofils **16** sont ensuite avantageusement encapsulés dans couche électriquement isolante **18**, par exemple en un matériau diélectrique tel que du benzocyclobutène (BCB) ou du polystyrène ou encore en matériau inorganique comme du SiO₂. Ladite couche d'encapsulation **18** est déposée de sorte que les extrémités des nanofils **16** dépassent de celle-ci. La couche d'encapsulation **18** a pour fonction de conférer une bonne planéité et est par exemple réalisée dans le cas d'un matériau inorganique comme SiO₂ au moyen d'un procédé de dépôt de type sol-gel (plus connu sous l'expression anglo-saxonne « *spin on glass* »), ou de type PECVD (pour « *plasma enhanced chemical vapor deposition »).*

Une couche **20** électriquement conductrice et au moins partiellement transparente à la lumière émise par les nanofils, est alors formée sur la couche d'encapsulation **18** de manière à englober l'extrémité libre des nanofils. La couche **20** forme ainsi une seconde électrode pour les nanofils tout en n'occultant pas la lumière émise par ceux-ci. La couche **20** est par exemple formée d'un matériau conducteur et semi-transparent tel que de l'I'TO (pour « *indium tin oxyde* ») ou d'oxyde de zinc (ZnO) ou d'une fine couche de nickel (Ni), de quelques nanomètres d'épaisseur (par exemple 5 nanomètres), recouverte d'une fine couche d'Au de quelque nanomètres d'épaisseur également (par exemple 5 nanomètres).

Des zones de reprise de contact électrique **22**, par exemple métalliques, sont alors réalisées selon un motif régulier sur la couche **20**.

Les étapes de formation des nanofils **16**, d'encapsulation de ceux-ci dans la couche **18**, de formation de la seconde électrode **20** et de réalisation des zones de reprise de contact électrique **22** sont par exemple décrites dans le document WO 2007/141333.

Le procédé se poursuit (figure 5) par l'individualisation de zones émissives élémentaires **24**, comprenant chacune une zone **22** de reprise de contact. Pour ce faire, on réalise un masquage desdites zones émissives élémentaires **24**, puis différentes étapes successives de gravure sont mises en oeuvre pour éliminer les portions non masquées de la seconde électrode **20**, de la couche d'encapsulation **18** et des nanofils **16**, afin de libérer la première électrode **14**. L'étape d'individualisation sera expliquée plus en détail par la suite. Une surface libre **26** de cette dernière dépasse au moins partiellement de chaque zone élémentaire **24**, ou entoure celle-ci.

Les zones émissives élémentaires **24** sont ensuite électriquement isolées (figure 6) par photolithographie, gravure ou ablation laser. Une tranchée **28** est ainsi réalisée autour de chaque zone élémentaire **24** dans la première électrode **26** jusqu'à la couche isolante **12**.

Il est ainsi obtenu un dispositif d'émission de lumière à base de diodes électroluminescentes à base de nanofils **24** comprenant une première électrode élémentaire **30**, sur laquelle sont formés des nanofils **16** encapsulés dans une couche d'encapsulation **18** et recouverts d'une seconde électrode élémentaire **32**, sur laquelle est formée une zone de reprise de contact électrique **22**.

Le procédé se poursuit ensuite (figure 7) par la mise en série électrique des diodes électroluminescentes **24**. De manière avantageuse, la mise en série est réalisée à l'aide d'un fil d'Au **34** reliant une zone de reprise de contact **22** d'une diode **24** avec la première électrode élémentaire **30** d'une diode adjacente, par exemple à l'aide de la technique dite *« wire ball* » ou « *wedge bounding* ». La première électrode élémentaire **30** d'une diode périphérique **36** est alors connectée par un fil d'or à des bornes d'alimentation électrique comprenant par exemple une portion de la couche conductrice **12**.

On notera par ailleurs que la formation des zones de reprises de contact ainsi que la formation des zones élémentaires d'émission font avantageusement appel à des techniques de masquage. Il est ainsi possible d'agencer les zones de reprise de contact électrique et la surface accessible des premières électrodes élémentaires de manière à minimiser la résistance électrique entre les zones élémentaires d'émission.

Enfin, le procédé se termine (figure 8) par le dépôt d'un matériau luminophore **38** sur l'ensemble ainsi obtenu pour définir et ajuster la couleur d'émission finale. Par exemple lorsque les diodes **24** émettent une couleur bleue, un dispositif d'émission de lumière blanche est réalisé en utilisant un matériau luminophore du type grenat YAG dopé au Ce, comme par exemple du Y₃Al₅O₁₂ :Ce³⁺.

La figure 9 illustre une variante d'interconnexion électrique des diodes électroluminescente. Dans cette variante, une couche de passivation **40** électriquement isolante est d'abord déposée partiellement sur chaque zone de reprise de contact **22** et le fond de la tranchée **28**, par exemple une couche de passivation inorganique en SiO₂ ou en Si₃N₄, ou bien une couche de passivation organique en silicone, epoxy, acrylique, polyimide ou benzocyclobutène.

Une couche métallique **42** est alors déposée sur la surface libre de la zone **22** et de la tranchée **28** et recouvre partiellement la première électrode élémentaire **30** d'une diode électroluminescente adjacente.

En variante, le raccordement électrique des diodes électroluminescentes est réalisée au moyen d'une interconnexion collective de grande surface, comme par exemple des lignes conductrices métalliques réalisées par sérigraphie d'un adhésif conducteur, tel qu'un adhésif avec une charge d'Ag rendu conducteur par réticulation, ou par jet d'une encre conductrice, telle qu'une encre à base de nanoparticules d'Ag qui est rendu conductrice par frittage à basse température.

L'interconnexion filaire des diodes électroluminescentes est toutefois préférée dans le cas d'un substrat **10** souple. En effet, l'utilisation d'une technologie de diodes électroluminescentes à base de nanofils autorise l'utilisation d'une grande variété de substrats, et notamment des substrats souples particulièrement avantageux dans les systèmes de rétroéclairage par LCD, les panneaux lumineux pour l'éclairage industriel ou domestique ou autres. L'utilisation d'interconnexions filaires entre les diodes autorise aussi lors de la déformation du substrat que les diodes sont toujours raccordées sans rupture de leur interconnexion.

L'interconnexion électrique de grande surface (adhésif, encre, dépôt de couche) est quant à elle avantageuse dans les dispositifs d'émission de lumière à base de diodes de très grande surface. Les techniques de mise en oeuvre de ces matériaux sont en effet plus faciles à mettre en oeuvre pour des grandes surfaces.

Il a été décrit une individualisation des diodes électroluminescentes dans laquelle des portions de la seconde électrode **20**, de la couche d'encapsulation **18** et des nanofils sont éliminées pour faire apparaître les zones émissives élémentaires **24** (figure 5).

La figure 10 illustre un problème fréquent de surgravure latérale apparaissant si l'élimination des nanofils est réalisée sans précaution particulière. Comme on peut le constater, lors de l'élimination de ces derniers, par exemple par gravure chimique, la première électrode **14** peut subir une gravure non souhaitée qui élimine une bonne partie de celle-ci entre les zones émissives **24** mais également sous lesdites zones. De fait, l'interconnexion électrique de la première électrode élémentaire d'une diode avec la zone de reprise de contact **22** d'une diode adjacente est difficile car il faut connecter une surface cachée sous la zone émissive.

Il va à présent être décrit des modes de réalisation des étapes d'individualisation des diodes électroluminescentes pour des matériaux de nanofils en GaN et ZnO. On comprendra évidemment que ces modes de réalisation associés auxdits matériaux ne sont pas limitatifs et servent à la fois à expliquer d'une part, le principe général de l'individualisation, et d'autre part, les spécificités de ladite individualisation au regard du matériau constitutif des nanofils.

Les figures 11 à 21 décrivent l'individualisation de diodes électroluminescentes à base de nanofils en GaN encapsulés, la figure 11 correspondant à une vue agrandie de la figure 4 avec un substrat métallique.

L'individualisation des zones émissives débute (figure 12) par le dépôt d'une résine de masquage **50** définissant les zones où les tranchées **28** vont être réalisées, par exemple par lithographie. Une gravure ionique réactive, ou gravure « RIE » (pour « *reactire ion etching* ») est alors mise en oeuvre pour éliminer la portion de seconde électrode **20** non masquée (figure 13). Cette gravure, à base d'une chimie méthane/hydrogène/argon, est choisie pour sélectivement attaquer l'électrode **20** et ne pas attaquer la couche d'encapsulation planarisante **18** et les nanofils **16**.

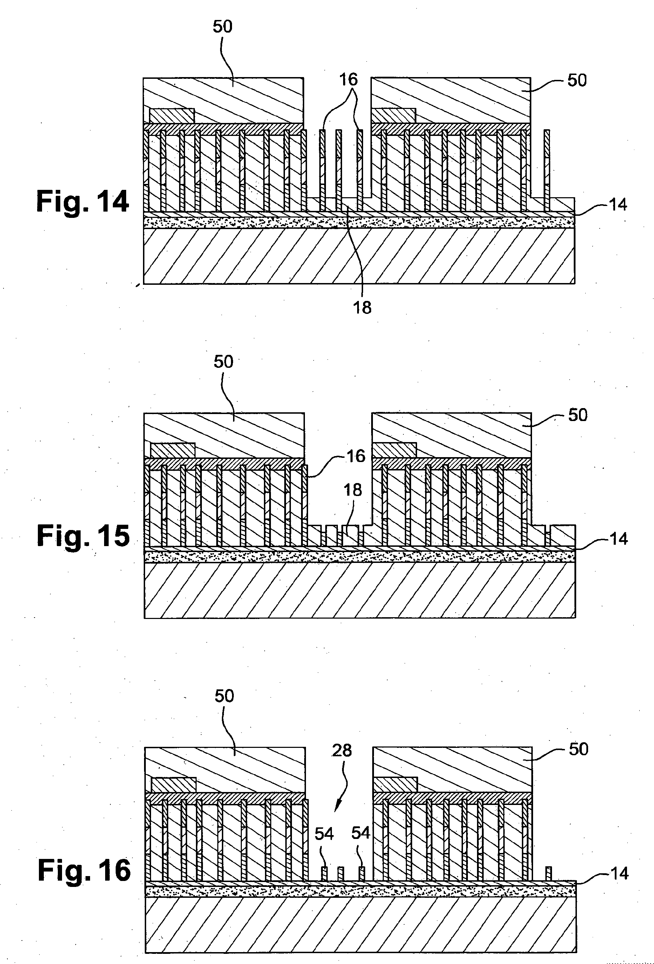

Une gravure RIE à base de chimie fluorée de type CHF₃/O₂ est ensuite mise en oeuvre pour éliminer partiellement la portion de couche d'encapsulation **18** non masquée (figure 14). Selon l'invention, une faible épaisseur de la couche d'encapsulation **18** est laissée au fond de la gravure, par exemple une épaisseur de quelques dizaines de manomètres, par exemple entre 20 et 200 nm. Cette épaisseur a pour fonction de masquer la couche conductrice **14** lors de l'élimination des nanofils **16**. Par exemple, une calibration de la vitesse de gravure de la couche d'encapsulation **18** est réalisée sur des plaques témoins et est réglée par exemple à environ 100 nm/min.

Il convient de noter que l'épaisseur restante de la couche d'encapsulation en fond de gravure ne nécessite pas une précision élevée. Il convient uniquement de s'assurer de la présence d'une telle épaisseur afin de réaliser un masque de protection de la couche conductrice **14** lors de la gravure ultérieure des nanofils. Comme il sera apparent dans ce qui suit, l'invention tire avantageusement partie du fait que des portions de nanofils peuvent rester au fond des tranchées **28** formées pour individualiser les zones émissives élémentaires, l'épaisseur restante de la couche d'encapsulation **18** réglant la hauteur des portions restantes de nanofils. Bien évidemment, il est préférable que cette hauteur de nanofils soit minimale, mais les résidus de nanofils peuvent être avantageusement noyés dans une couche métallique si besoin est.

L'individualisation se poursuit alors (figure 15) par la mise en oeuvre d'une gravure RIE à base de SiCl₄/Cl₂ pour l'élimination sélective des nanofils non masqués. On note ainsi une surgravure des nanofils **16**, une portion de ceux-ci encapsulée dans l'épaisseur restante de la couche **18** ayant été éliminée. Toutefois, on notera que la couche conductrice **14** est intacte.

Une gravure RIE de l'épaisseur restante de la couche d'encapsulation **18** est alors mise en oeuvre (figure 16). Cette gravure sélective n'attaque pas la couche conductrice **14** ni les nanofils et laisse ainsi au fond de la tranchée des résidus de nanofils **54**. Ces résidus **54** forment des contacts ohmiques avec la couche conductrice **14** et ne constitue donc pas une gêne dans le fonctionnement ultérieur du dispositif d'émission de lumière à base de diodes électroluminescentes.

La résine de masquage **50** est alors éliminée (figure, 17) par exemple par un bain d'acétone suivi d'un plasma O₂ pour faire disparaître tous les résidus de résine.

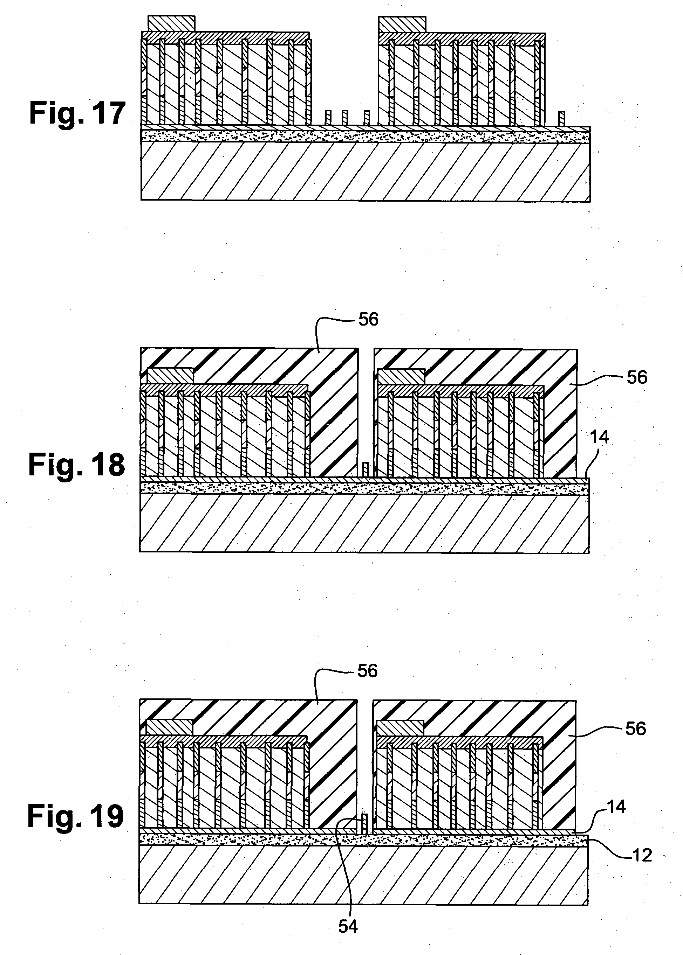

Une nouvelle résine **56**, par exemple formée par lithographie, est alors déposée sur l'ensemble obtenu (figure 18) pour définir les zones de gravure de la couche conductrice **14** puis une gravure est réalisée (figure 19) jusqu'à la couche isolante **12**. Si la couche conductrice **14** est réalisée en Au ou Ag, une gravure chimique humide à base d'iode et de iodure de potassium est mise en oeuvre. Si la couche **14** est réalisée en titane, une gravure RIE à base de SF₆ ou à base de chimie fluorée est mise en oeuvre. Si la couche **14** est en TiN, une gravure RJE à base de chimie fluorée est mise en oeuvre. Enfin pour des métaux nobles, du type Pt, la gravure de la couche conductrice **14** est une gravure ionique, ou gravure IBE (pour « *ion beam etching* »).

On notera qu'un choix judicieux du matériau constitutif de la couche **14** et du type de gravure permet d'éliminer les résidus **54** de nanofils non masqués. Par exemple, une gravure humide sur-gravera la portion de couche conductrice **14** sous ces résidus.

La résine **56** est alors éliminée (figure 20) par exemple à l'aide d'un bain d'acétone suivi de l'application d'un plasma O₂.

Une interconnexion filaire entre deux diodes adjacentes est alors réalisée entre la surface libérée de la première électrode d'une diode, avec la zone de reprise de contact **22** formée sur la seconde électrode de l'autre diode (figure 21).

Les figures 22 à 35 illustre l'individualisation de diodes électroluminescentes à base de nanofils en ZnO.

Sur la figure 22, les nanofils de ZnO **16** sont avantageusement directement conçus sur un substrat **10** isolant ou semi-isolant, par exemple formé en saphir ou silicium. Le substrat **10** joue ainsi également le rôle de la couche isolante **12** précédemment décrite.

Lors de la croissance des nanofils **16**, notamment par MOCVD (pour « *metal-organic chemical vapor deposition* »), une couche continue en ZnO, dite de « buffer », d'une centaine de nanomètres d'épaisseur est également formée. Cette couche de buffer joue ainsi le rôle de la couche conductrice **14** précédemment décrite et permet ainsi de relier électriquement entre eux les nanofils **16**. La couche d'encapsulation planarisante **18** est quant à elle constituée par exemple d'un matériau inorganique, tel que du SiO₂, et est formée par exemple au moyen d'un dépôt de type sol-gel ou d'un dépôt PECVD. La couche **20** formant la seconde électrode est quant à elle constituée d'un matériau du type ITO et les zones de reprise de contact électrique **22** sont des zones bicouches métalliques du type Ti/Au ou Ni/Au.

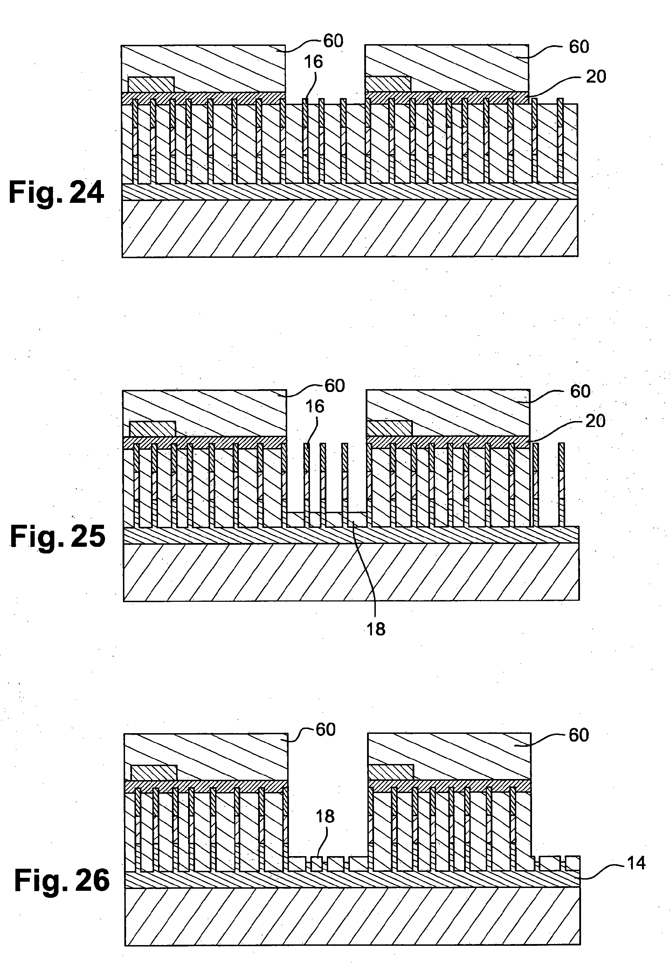

L'individualisation des diodes débute (figure 23) par le dépôt d'un masque en résine **60** par photolithographie (figure 23), suivie par la gravure sélective de la couche **20** du type RIE à base de chimie méthane/hydrogène/argon (figure 24).

La couche d'encapsulation **18** subit ensuite une gravure RIE (figure 25) à base de chimie fluorée du type CHF₃/O₂ d'une manière analogue à celle décrite précédemment en relation avec les figures 11-20.

Les nanofils non masqués sont alors gravés (figure 26) à l'aide d'une gravure RIE lente (de l'ordre de 10nm/mn) à base de chlorure d'ammonium, l'épaisseur de couche d'encapsulation restante formant un masque pour la couche de buffer conductrice **14**.

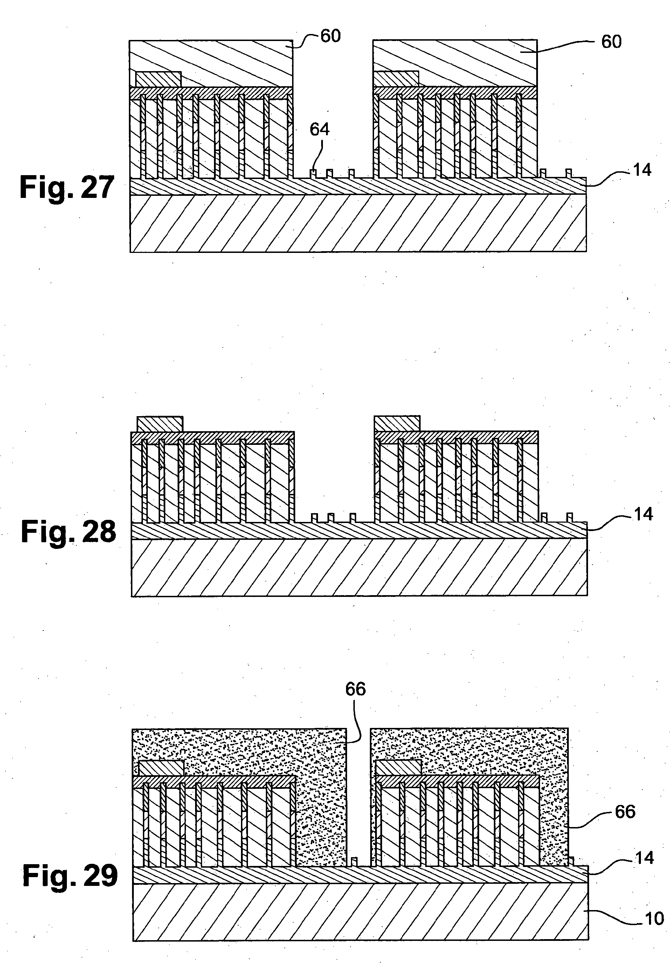

Le reste de la couche d'encapsulation **18** est alors ôté à l'aide de la gravure RIE fluorée (figure 27). Tout comme le mode de réalisation précédemment décrit, des résidus **64** de nanofils peuvent être présents mais ne constituent pas une gêne en soi puisqu'ils forment de simples contacts ohmiques avec la couche conductrice de buffer **14**. Le masque de résine **60** est alors retiré par un bain d'acétone suivi de l'application d'un plasma O₂ (figure 28).

Un nouveau masque de résine **66** est alors formé par lithographie pour le gravage de la couche conductrice jusqu'au substrat isolant ou semi-isolant **10** (figure 29), puis une gravure humide à base de chlorure d'ammonium est réalisée pour graver la portion de couche **14** non masquée (figure 30). Le masque de résine **66** est alors ôté par de l'acétone et le plasma O₂ (figure 31).

De manière avantageuse, un contact métallique est réalisé sur la première électrode élémentaire issue de la couche de buffer **14** de chaque diode individualisée, afin d'améliorer le contact électrique entre le fil d'or ultérieurement formé et cette couche buffer **14.**

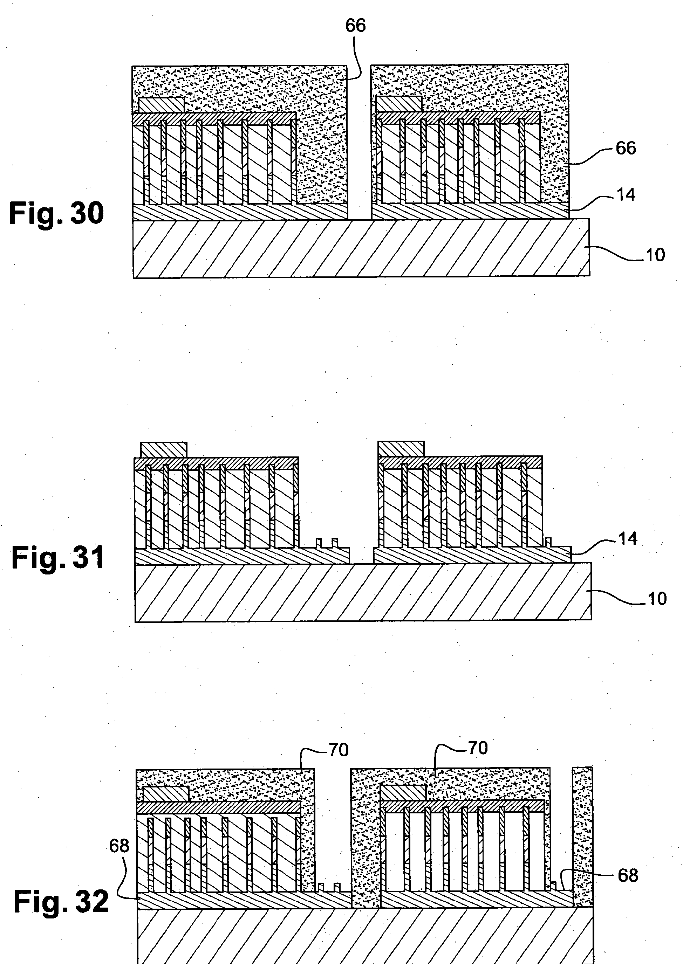

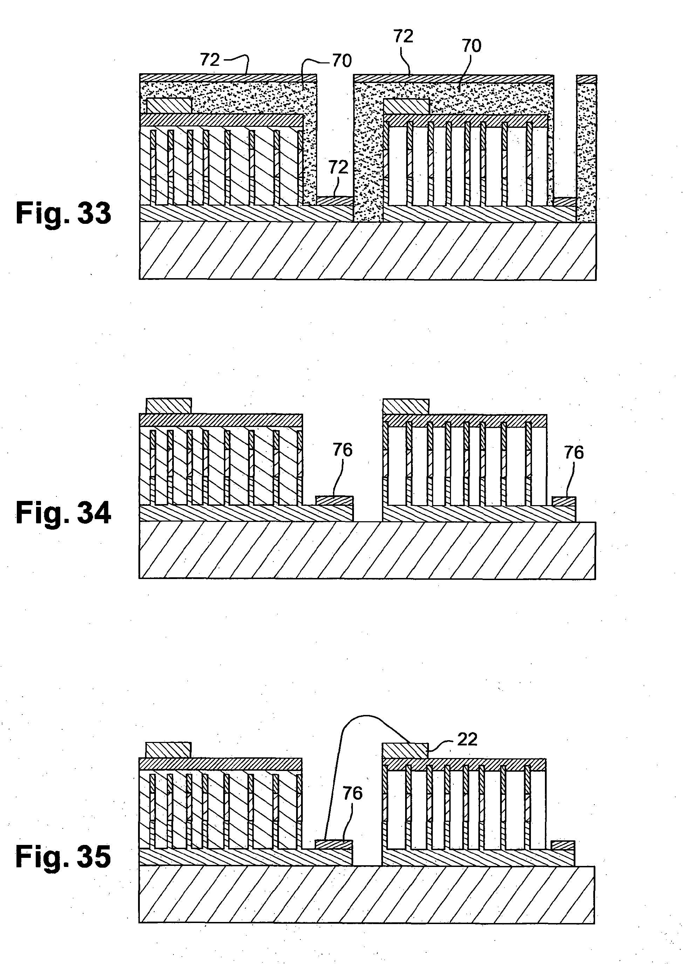

Pour ce faire, un nouveau masque de résine **70** est formé par photolithographie (figure 32) et du métal **72** est déposé par évaporation ou pulvérisation sur l'ensemble, comme par exemple un matériau bicouche de Ti/Au ou Ni/Au (figure 33).

Le masque de résine **70** est alors ôté par de l'acétone et du plasma O₂ (figure 34).

Il reste ainsi une zone métallique de reprise de contact **76** sur chaque première électrode élémentaire des diodes.

Une interconnexion filaire entre deux diodes adjacentes est alors réalisée entre la zone de reprise de contact **16** d'une diode, formée sur la première électrode, avec la zone de reprise de contact **22** formée sur la seconde électrode de l'autre diode. (figure 35).

Il a été décrit des modes de réalisation dans lesquels une couche d'encapsulation des nanofils est utilisée, notamment pour offrir une surface plane pour la seconde électrode transparente ou semi-transparente des diodes.

En variante, on n'utilise aucune couche d'encapsulation, et l'extrémité des nanofils est élargie pour recevoir la seconde électrode, comme cela est illustré à la figure 36.

Sur cette figure, des nanofils en GaN **16** sont formés sur la couche conductrice **16**, elle-même formée sur la couche isolante 12 déposée sur le substrat **10**, par exemple métallique. Chacun des nanofils **16** comprend par ailleurs une extrémité **80** s'évasant vers le haut et présentant ainsi une surface plane importante pour recevoir la seconde électrode **20**. De préférence, la densité surfacique des nanofils est importante de sorte que leur extrémité évasée se rejoignent pour former une surface plane continue.

De manière analogue aux modes de réalisation précédemment décrits, l'individualisation des diodes électroluminescentes débute par la formation d'un masque de résine par photolithographie suivi d'une gravure RIE de la portion de couche **20** non masquée (figure 37), par exemple une gravure RIE à base de méthane/hydrogène/argon qui n'attaque pas les nanofils en GaN.

L'individualisation se poursuit alors (figure 38) par la gravure RIE à base de SiCl₄/Cl₂ des nanofils **16**. La couche conductrice **14** formant la première électrode est avantageusement choisie pour être sensiblement inerte à ce type de gravure RIE, et est par exemple formée de Pt, de Ni, d'Au, d'Ag, de Ti ou de TiN. En outre, par s'assurer que la couche conductrice **14** ne soit pas gravée, la gravure des nanofils **16** est stoppée avant leur élimination complète, de sorte que des résidus **84** de ceux-ci subsistent.

Après avoir ôté le masque de résine **82** par un bain d'acétone et par application d'un plasma O₂, un nouveau masque de résine **86** est formé pour isoler électriquement les diodes, puis on réalise une gravure de la portion non masquée de la couche conductrice **14** (figure 39).

Lorsque cette dernière est réalisée avec des métaux nobles du type Pt ou Ni, une gravure IBE est utilisée. Lorsque la couche **14** est par contre formée d'Au ou d'Ag, une solution chimique à base d'iode et de iodure de potassium est utilisée. Enfin, lorsque la couche **14** est constituée de Ti ou de TiN, une gravure sèche à base de chimie fluorée est mise en oeuvre.

Tout comme le mode de réalisation des figures 11 à 21, une gravure humide permet de surgraver la portion de couche sous les résidus de nanofils **84**, ce qui élimine ceux-ci. Enfin, après avoir ôté le masque de résine **86**, les diodes individualisées sont mises en série, par exemple au moyen d'interconnexions filaires en Au (figure 40). Si des résidus de nanofils gênent l'opération d'interconnexion filaire, un dépôt métallique supplémentaire au fond de la tranchée est alors réalisé d'une manière analogue à celle décrite précédemment en relation avec les figures 22 à 35.

La figure 41 illustre une vue en section un mode de réalisation privilégié du substrat **10**, qui prend la forme d'un radiateur à ailettes. La taille du radiateur, la taille des ailettes et la distance séparant lesdites ailettes définissant notamment la capacité de dissipation thermique du radiateur. Ce dernier est ainsi conçu selon la puissance calorifique dégagée par le dispositif d'émission de lumière à base de diodes selon l'invention. Des radiateurs à forte dissipation thermique sont par exemples conçus par la société SEEM-SEMRAC à Pont-Audemer, France. Quelques exemples de ces radiateurs sont visibles à l'adresse http://www.seem-semrac.com/seem/1Dissip/dissipC.htm

Par ailleurs, le radiateur peut être traversé de part en part par des canaux permettant de faire circuler un fluide (refroidissement à eau ou à air par exemple), ou le radiateur peut comprendre des structures de type caloduc.

Grâce à l'invention, il est obtenu les avantages suivants :
▪ le module émetteur de lumière selon l'invention comprend un nombre limité de résistances thermiques. En effet, il n'existe aucun report par brasage, collage ou autre technique des diodes électroluminescentes élaborées. Par ailleurs, toutes les résistances thermiques liées à des matériaux de report ou de matériaux de substrat de croissance, ou des matériaux des boitiers de l'état de la technique sont éliminées ;
▪ les matériaux du substrat peuvent être choisis parmi les matériaux bon conducteurs de la chaleur, comme des métaux par exemple, ce qui augmente encore la dissipation thermique;
▪ il est possible de réaliser les diodes électroluminescentes sur un substrat en forme de radiateur, par exemple à ailettes, et cela sans aucun report. La dissipation thermique est de ce fait encore améliorée ;
▪ la taille des substrats de saphir ou de SiC usuellement utilisés dans l'état de la technique pour réaliser des diodes par épitaxie est généralement inférieure à 100 mm de diamètre. Les nanofils pouvant être réalisés sur des substrats métalliques, inorganiques ou céramiques, il n'existe plus de limite de taille pour le substrat. Ainsi, un dispositif d'émission de lumière à base de diodes électroluminescentes de la taille d'un écran de télévision pour assurer le rétroéclairage des écrans plats dits « LCD » peut être réalisé. De même, il est possible de concevoir des éclairages sur une surface plus grande, par exemple de la taille d'une fenêtre de bâtiment ou d'un plafond ;
▪ les diodes électroluminescentes selon l'invention étant mises électriquement en série, il n'existe donc pas de limitation dans la longueur des interconnexions, et la densité de courant injecté pour alimenter les diodes est homogène sur tout le dispositif d'émission de lumière à base de diodes, évitant ainsi l'apparition de point chaud par exemple. En outre la mise en série électrique des diodes permet une commande en tension alternative ou continue de celles-ci, par exemple par la tension du réseau domestique ; par exemple la mise en série de 60 diodes sur une tension secteur d'environ 240 V permet d'alimenter chaque diode individuellement à une tension moyenne de 3 V.
▪ grâce aux nanofils, il est possible d'utiliser un substrat déformable comme une feuille métallique, une feuille de graphite ou autres. Il est ainsi possible de réaliser un module d'émission de lumière ayant des formes tridimensionnelles particulières Le substrat peut par exemple être enroulé autour d'un cylindre formant radiateur, ou légèrement déformé pour augmenter l'angle d'émission du luminaire. Il est également possible d'envisager un module lumineux en forme de nappe se posant par exemple sur les bras d'un canapé dont il prend la forme ;
▪ le substrat n'étant pas ôté et restant intact, il est possible de laisser sur celui-ci des zones libres avec des zones d'interconnexion sur lesquelles seront reportés des composants passifs, comme par exemple des résistances, des capacités, des diodes, des composants actifs, comme des drivers, ou encore des composants de gestion des surtensions ou de décharges électrostatiques, notamment des diodes Zener.

## Revendications

1. Procédé de fabrication d'un dispositif d'émission de lumière à base de diodes électroluminescentes comprenant :
▪ la formation d'un support (10, 12) formant échangeur thermique ;
▪ la formation d'une première électrode (14) sur le support (10, 12) ;
▪ la croissance de nanofils semi-conducteurs (16) émetteurs de lumière sur la première électrode (14) ;
▪ l'encapsulation des nanofils (16) dans un matériau planarisant (18) ;
▪ la formation, sur le matériau planarisant (18), d'une seconde électrode (20) apte à transmettre au moins partiellement la lumière émise par les nanofils (16) ;
- la formation de zones de reprise de contact électrique (22) sur la seconde électrode (20) ;
***caractérisé***:
▪ en ce que le support (10, 12) présente une face électriquement isolante sur laquelle est formée la première électrode (14) ;
▪ et en ce qu'il comporte :
∘ la formation des diodes électroluminescentes (24) par :
▪ libération d'une bande dé première électrode autour de chaque zone de reprise de contact (22) comportant :
- la formation d'un masque de délimitation desdites bandes sur la surface de la seconde électrode ;
- une première gravure chimique du matériau planarisant, la gravure chimique étant stoppée de manière à conserver du matériau planarisant sur la première électrode ;
- une seconde gravure chimique de la portion de nanofils libérée du matériau planarisant lors de la première gravure chimique ; et
- une troisième gravure chimique de matériau planarisant restant à l'issue de la première attaque chimique,
▪ et la formation d'une tranchée (28) le long de chacune desdites bandes jusqu'à la face électriquement isolante du support (10, 12) ;
∘ et la mise en série des diodes électroluminescentes (24) par la connexion électrique des zones de reprise de contact électrique (22) et des bandes de première électrode.

2. Procédé de fabrication d'un dispositif d'émission de lumière à base de diodes électroluminescentes comprenant :
▪ la formation d'un support (10, 12) formant échangeur thermique ;
▪ la formation d'une première électrode (14) sur la face électriquement isolante du support (10, 12) ;
▪ la croissance de nanofils semi-conducteurs (16) émetteurs de lumière sur la première électrode (14) ;
▪ la formation, sur l'extrémité libre des nanofils (16), d'une seconde électrode (20) apte à transmettre au moins partiellement la lumière émise par les nanofils (16) ;
- la formation de zones de reprise de contact électrique (22) sur la seconde électrode (20) ;
***caractérisé***:
▪ en ce que le support (10, 12) présente une face électriquement isolante sur laquelle est formée la première électrode (14) ;
▪ en ce que les extrémités libres (80) des nanofils (16) sont évasées et contigües de manière à former un support pour la seconde électrode ;
▪ en ce que la première électrode (14) est réalisée en un matériau sensiblement inerte à une gravure chimique prédéterminée des nanofils (16),
▪ et en ce qu'il comporte :
∘ la formation des diodes électroluminescentes (24) par :
- libération d'une bande de première électrode autour de chaque zone de reprise de contact (22) comportant la formation d'un masque de délimitation desdites bandes sur la surface de la seconde électrode et l'application de ladite gravure chimique prédéterminée ;
- et la formation d'une tranchée (28) le long de chacune desdites bandes jusqu'à la face électriquement isolante du support (10, 12) ;
∘ la mise en série des diodes électroluminescentes (24) par la connexion électrique des zones de reprise de contact électrique (22) et des bandes de première électrode.

3. Procédé de fabrication d'un dispositif d'émission de lumière à base de diodes électroluminescentes selon la revendication 1 ou 2, dans lequel la formation du support (10, 12) comporte la formation d'ailettes de dissipation thermique sur la face opposée à la face électriquement isolante.

4. Procédé de fabrication d'un dispositif d'émission de lumière à base de diodes électroluminescentes selon la revendication 1, 2 ou 3, dans lequel la formation du support comporte le dépôt d'une couche isolante (12) sur un substrat conducteur d'électricité (10).

5. Procédé de fabrication d'un dispositif d'émission de lumière à base de diodes électroluminescentes selon la revendication 4, dans lequel la couche isolante (12) est une couche de matériau inorganique, notamment du diamant, de l'AlN, du SiC. BN, ou du Si₃N₄ ou du SiO₂.

6. Procédé de fabrication d'un dispositif d'émission de lumière à base de diodes électroluminescentes selon l'une quelconque des revendications précédentes, dans lequel la première électrode (14) comporte une première couche de matériau d'interconnexion, notamment en Ti, en Cr, en TiN ou en WN, et une seconde couche mince, déposée sur la première couche, de matériau de forte conductivité électrique, notamment du Cu, de l'Au, l'Ag, du W, du Ni, ou du Pd..

7. Procédé de fabrication d'un dispositif d'émission de lumière à base de diodes électroluminescentes selon l'une quelconque des revendications 1 à 5, dans lequel les nanofils (16) sont constitués de ZnO et la première électrode est une couche de ZnO.

8. Procédé de fabrication d'un dispositif d'émission de lumière à base de diodes électroluminescentes selon l'une quelconque des revendications précédentes, dans lequel les connexions électriques sont réalisée par câblage filaire (36), notamment en fil d'Au.

9. Procédé de fabrication d'un dispositif d'émission de lumière à base de diodes électroluminescentes selon l'une quelconque des revendications précédentes, dans lequel un matériau luminophore est déposé au voisinage des zones émissives pour définir et ajuster la couleur de l'émission de lumière.

## Patentansprüche

1. Fertigungsverfahren für eine lichtemittierende Vorrichtung auf Basis von Leuchtdioden, bestehend aus:
• der Bildung eines Trägers (10, 12), der einen Wärmetauscher bildet;
• der Bildung einer ersten Elektrode (14) auf dem Träger (10, 12);
• dem Wachstum von lichtemittierenden Halbleiter-Nanodrähten (16) auf der ersten Elektrode (14);
• der Verkapselung der Nanodrähte (16) in einem einebnenden Material (18);
• der Bildung, auf dem einebnenden Material (18), einer zweiten Elektrode (20), die in der Lage ist, zumindest teilweise das von den Nanodrähten (16) emittierte Licht zu übertragen,
• der Bildung von Zonen zur elektrischen Kontaktierung (22) auf der zweiten Elektrode (20);
**dadurch gekennzeichnet;**
• **dass** der Träger (10, 12) eine elektrisch isolierende Seite aufweist, auf der die erste Elektrode (14) gebildet wird;
• und dadurch, dass er:
o die Bildung von Leuchtdioden (24) durch:
• Freisetzung eines ersten Elektrodenstreifens um jede Kontaktierungszone (22) herum, umfassend:
- die Bildung einer Begrenzungsmaske für diese Streifen auf der Oberfläche der zweiten Elektrode;
- ein erstes chemisches Ätzen des einebnenden Materials, wobei das chemische Ätzen unterbrochen wird, damit einebnendes Material auf der ersten Elektrode zurückbleibt;
- ein zweites chemisches Ätzen des Teils der Nanodrähte, die beim ersten chemischen Ätzen vom einebnenden Material befreit wurden; und
- ein drittes chemisches Ätzen des einebnenden Materials, das nach der ersten chemischen Behandlung noch zurückblieb;
• und Bildung einer Vertiefung (28) entlang jedes dieser Streifen bis zur elektrisch isolierenden Seite des Trägers (10, 12);
∘ und die Serienschaltung der Leuchtdioden (24) durch elektrische Verbindung der elektrischen Kontaktierungszonen (22) und der Streifen der ersten Elektrode enthält.

2. Fertigungsverfahren für eine lichtemittierende Vorrichtung auf Basis von Leuchtdioden, bestehend aus:
• der Bildung eines Trägers (10, 12), der einen Wärmetauscher bildet;
• der Bildung einer ersten Elektrode (14) auf der elektrisch isolierenden Seite des Trägers (10, 12);
• dem Wachstum von lichtemittierenden Halbleiter-Nanodrähten (16) auf der ersten Elektrode (14);
• der Bildung, am freien Endstück der Nanodrähte (16), einer zweiten Elektrode (20, die in der Lage ist, zumindest teilweise das von den Nanodrähten (16) emittierte Licht zu übertragen;
• der Bildung von Zonen zur elektrischen Kontaktierung (22) auf der zweiten Elektrode (20);
**dadurch gekennzeichnet,**
• **dass** der Träger (10, 12), eine elektrisch isolierende Seite aufweist, auf der die erste Elektrode (14) gebildet wird;
• **dass** die freien Endstücke (80) der Nanodrähte (16) aufgeweitet sind und aneinander angrenzen, so dass sie einen Träger für die zweite Elektrode bilden;
• dadurch dass die erste Elektrode (14) aus Material hergestellt ist, das gegenüber einem vorher bestimmten chemischen Ätzen der Nanodrähte (16) deutlich inert ist;
• und dadurch, dass es:
∘ die Bildung von Leuchtdioden (24) durch
- Freisetzung eines ersten Elektrodenstreifens um jede Kontaktierungszone (22) herum, die die Bildung einer Begrenzungsmaske für diese Streifen auf der Oberfläche der zweiten Elektrode und das Auftragen des vorher festgelegten chemischen Ätzens;
- und Bildung einer Vertiefung (28) entlang jedes dieser Streifen, bis zur elektrisch isolierenden Seite des Trägers (10, 12);
∘ die Serienschaltung der Leuchtdioden (24) durch elektrische Verbindung der elektrischen Kontaktierungszonen (22) und der Streifen der ersten Elektrode enthält.

3. Fertigungsverfahren für eine lichtemittierende Vorrichtung auf Basis von Leuchtdioden nach Anspruch 1 oder 2, bei dem die Bildung des Trägers (10, 12) die Bildung von Rippen zur Wärmeverteilung auf der Seite, die gegenüber der elektrisch isolierenden Seite liegt, umfasst.

4. Verfahren zur Herstellung einer lichtemittierenden Vorrichtung auf Basis von Leuchtdioden gemäß Anspruch 1, 2 oder 3, in der die Bildung des Trägers die Ablagerung einer isolierenden Schicht (12) auf einem stromleitenden Substrat (10) umfasst.

5. Fertigungsverfahren für eine lichtemittierende Vorrichtung auf Basis von Leuchtdioden gemäß Anspruch 4, bei dem die Isolierschicht (12) eine Schicht aus anorganischem Material ist, insbesondere Diamant, AlN, SiC, BN, oder Si₃N₄ oder SiO₂.

6. Fertigungsverfahren für eine lichtemittierende Vorrichtung auf Basis von Leuchtdioden nach irgendeinem der vorangehenden Ansprüche, bei dem die erste Elektrode (14) eine erste Schicht Verbindungsmaterial, insbesondere aus Ti, aus Cr, aus TiN oder aus WN, und eine zweite, auf der ersten Schicht abgelagerte dünne Schicht, bestehend aus einem Material mit hoher elektrischer Leitfähigkeit, insbesondere Cu, Au, Ag, W, Ni, oder Pd enthält.

7. Fertigungsverfahren für eine lichtemittierende Vorrichtung auf Basis von Leuchtdioden nach irgendeinem der vorangehenden Ansprüche 1 bis 5, bei dem die Nanodrähte (16) aus ZnO bestehen und die erste Elektrode eine ZnO-Schicht ist.

8. Fertigungsverfahren für eine lichtemittierende Vorrichtung auf Basis von Leuchtdioden, nach irgendeinem der vorangehenden Ansprüche, bei dem die elektrischen Verbindungen durch Drahtverkabelung (36), vor allem mit Au-Drähten, ausgeführt sind.

9. Fertigungsverfahren für eine lichtemittierende Vorrichtung auf Basis von Leuchtdioden nach irgendeinem der vorangehenden Ansprüche, bei dem ein luminophores Material in der Nähe der emittierenden Zonen abgelagert wird, um die Farbe der Lichtemission zu definieren und anzupassen.

## Claims

1. A method of manufacturing a light emission device based on light emitting diodes, comprising:
▪ the formation of a support (10, 12) forming a heat exchanger;
▪ the formation of a first electrode (14) on the support (10, 12);
▪ the growth of semiconducting light-emitting nanowires (16) on the first electrode (14);
▪ the encapsulation of the nanowires (16) in a planarising material (18);
▪ the formation, on the planarising material (18), of a second electrode (20) able to at least partially transmit the light emitted by the nanowires (16);
▪ the formation of areas for taking up electrical contact (22) on the second electrode (20);
***characterised***:
▪ in that the support (10, 12) has an electrically insulating face on which the first electrode (14) is formed;
▪ and in that it comprises:
∘ the formation of the light emitting diodes (24) by:
▪ releasing a band of the first electrode around each contact take-up area (22), comprising:
- the formation of a mask defining said bands on the surface of the second electrode;
- a first chemical etching of the planarising material, the chemical etching being stopped so as to preserve planarising material on the first electrode;
- a second chemical etching of the portion of nanowires released from the planarising material during the first chemical etching; and
- a third chemical etching of planarising material remaining at the end of the first chemical etching,
▪ and the formation of a trench (28) along each of the said bands as far as the electrically insulating face of the support (10, 12);
∘ and placing the light emitting diodes (24) in series by electrically connecting the electrical contact take-up areas (22) and the bands of the first electrode.

2. A method of manufacturing a light emission device based on light emitting diodes, comprising:
▪ the formation of a support (10, 12) forming a heat exchanger;
▪ the formation of a first electrode (14) on the electrically insulating face of the support (10, 12);
▪ the growth of light-emitting semiconducting nanowires (16) on the first electrode (14);
▪ the formation, on the free end of the nanowires (16), of a second electrode (20) able at least partially to transmit the light emitted by the nanowires (16);
▪ the formation of electrical contact take-up areas (22) on the second electrode (20);
***characterised:***
▪ in that the support (10, 12) has an electrically insulating face on which the first electrode (14) is formed;
▪ in that the free ends (80) of the nanowires (16) are splayed and contiguous so as to form a support for the second electrode;
▪ in that the first electrode (14) is produced from a material substantially inert to a predetermined chemical etching of the nanowires (16),
▪ and in that it comprises:
∘ the formation of light emitting diodes (24) by:
- the release of a band of the first electrode around each contact take-up area (22) comprising the formation of a mask defining said bands on the surface of the second electrode and the application of said predetermined chemical etching;
- and the formation of a trench (28) along each of said bands as far as the electrically insulating face of the support (10, 12);
∘ putting the light emitting diodes (24) in series through the electrical connection of the electrical contact take-up areas (22) and the bands of the first electrode.

3. The method of manufacturing a light emission device based on light emitting diodes as claimed in claim 1 or 2, in which the formation of the support (10, 12) comprises the formation of thermal dissipation fins on the face opposite to the electrically insulating face.

4. The method of manufacturing a light emission device based on light emitting diodes as claimed in claim 1, 2 or 3, in which the formation of the support comprises the deposition of an insulating layer (12) on an electrically conductive substrate (10).

5. The method of manufacturing a light emission device based on light emitting diodes as claimed in claim 4, in which the insulating layer (12) is a layer of inorganic material, in particular diamond, AlN, SiC, BN, or Si₃N₄ or SiO₂.

6. The method of manufacturing a light emission device based on light emitting diodes as claimed in any one of the preceding claims, in which the first electrode (14) comprises a first layer of interconnection material, in particular made from Ti, Cr, TiN or WN, and a second thin layer, deposited on the first layer, of material with a high electrical conductivity, in particular Cu, Au, Ag, W, Ni or Pd.

7. The method of manufacturing a light emission device based on light emitting diodes as claimed in any one of claims 1 to 5, in which the nanowires (16) consist of ZnO and the first electrode is a layer of ZnO.

8. The method of manufacturing a light emission device based on light emitting diodes as claimed in any one of the preceding claims, in which the electrical connections are produced by wiring (36), in particular Au wire.

9. The method of manufacturing a light emission device based on light emitting diodes as claimed in any one of the preceding claims, in which a luminophore material is deposited in the vicinity of the emissive areas in order to define and adjust the colour of the light emission.
